# EUROPEAN PATENT SPECIFICATION

(11) **EP 1 532 677 B1**
(45) Date of publication and mention of the grant of the patent: **03.08.2011**
(21) Application number: 03792600.3
(22) Date of filing: 26.08.2003
(51) Int. Cl.: H01L 21/762

(54) **RECYCLING A WAFER COMPRISING A BUFFER LAYER, AFTER HAVING TAKEN OFF A THIN LAYER THEREFROM**
WIEDERVERWERTUNG EINER HALBLEITERSCHEIBE, DIE EINE PUFFERSCHICHT ENTHÄLT, NACH DER ENTFERNUNG EINER DÜNNEN SCHICHT DAHER
RECYCLAGE D'UNE PLAQUETTE COMPRENANT UNE COUCHE TAMPON, APRES RETRAIT D'UNE COUCHE MINCE

(30) Priority: 26.08.2002 FR 0210587; 09.12.2002 US 431928 P
(43) Date of publication of application: 25.05.2005
(73) Proprietor: S.O.I.Tec Silicon on Insulator Technologies, 38190 Bernin (FR)
(72) Inventor: GHYSELEN, Bruno, F-38170 Seyssinet-Pariset (FR); AULNETTE, Cécile, F-38000 Grenoble (FR); OSTERNAUD, Bénédite, F-38120 Saint Egreve (FR); LE VAILLANT, Yves-Mathieu, F-38920 Crolles (FR); AKATSU, Takeshi, F-38330 Saint Nazaire Les Eymes (FR)
(74) Representative: Le Forestier, Eric
(86) International application number: PCT/IB2003/004143
(87) International publication number: WO 2004/019404

(56) References cited:
- EP-A- 0 926 709
- EP-A- 1 006 567
- EP-A- 1 039 513
- WO-A-01/11930
- WO-A-99/53539
- WO-A-2004/006311
- US-A1- 2002 072 130
- US-B1- 6 326 279
- US-B1- 6 375 738

## Description

The present invention relates to the recycling of a donor wafer comprising a buffer layer after transfer of a thin semiconductor layer from the donor wafer to a receiving substrate.

The term "buffer layer" generally refers to a transition layer between a first crystalline structure such as a substrate and a second crystalline structure having the prime function of modifying properties of the material, such as structural or stoichiometric properties or atomic surface recombination properties.

In the particular case of a buffer layer, the latter may make it possible to obtain a second crystalline structure, the lattice parameter of which differs substantially from that of the substrate.

To this end, the buffer layer may have a composition which varies gradually with thickness, the gradual variation of components of the buffer layer then being directly associated with a gradual variation of its lattice parameter.

It may also have a more complex form such as a variation in composition with a variable rate, a sign inversion of the rate or discontinuous jumps in composition, possibly completed with a constant composition layer for containing defects.

Mention is then made of a metamorphic (buffer) layer or of a metamorphic embodiment, such as a metamorphic epitaxy.

Produced on the buffer layer, a layer or a superposition of layers may be taken off from the donor wafer in order to be transferred to a receiving substrate, in order to produce a particular structure.

One of the major applications of transferring thin layers formed on a buffer layer relates to the formation of strained silicon layers.

A layer is made of a material which is "strained" in tension or in compression if its lattice parameter in the interface plane is respectively greater or less than its nominal lattice parameter.

Otherwise, a layer is said to be made of a "relaxed" material if the latter is substantially close to its nominal lattice parameter, a nominal lattice parameter being the lattice parameter of the material in its bulk form in equilibrium.

When a layer is made of silicon strained in tension, some properties, such as the electron mobility of the material, are clearly improved.

Other materials, such as for example SiGe, may also be subject to a substantially similar taking-off.

The transfer of such layers onto a receiving substrate in particular by a process called Smart-cut©, and known to a person skilled in the art, then makes it possible to produce structures such as SOI (Semiconductor On Insulator) structures.

For example, after taking a layer off relaxed SiGe, the structure obtained may then act as a support for growing silicon.

Since the nominal lattice parameter of SiGe (dependent on the germanium content) is greater than the nominal lattice parameter of silicon, growth of silicon on the SGOI (Silicon-Germanium On Insulator) pseudo-substrate obtained makes it possible to provide the silicon layer strained in tension.

As an illustration, an example of such a process is described in the IBM document by L.J. Huang et al. ("SiGe-On-Insulator prepared by wafer bonding and layer transfer for high-performance field-effect transistors", Applied Physics Letters, 26/02/2001, vol. 78, No. 9) in which a method of producing an Si/SGOI structure is presented.

Another examples of such a process is given in the document US 2002/007481.

Other applications of metamorphic growth are possible, especially with semiconductors of the III-V family.

Thus, transistors are commonly produced using GaAs-based or InP-based technologies.

In terms of electron performance, InP has a substantial advantage over GaAs, in particular, a combination of an InP layer and an InGaAs or InAlAs layer makes it possible to improve electron mobilities.

However, the ability to market components using InP technology is limited faced with GaAs technology, particularly in terms of cost, availability, mechanical weakness and the size of bulk substrates (the maximum diameter for InP typically being 4 inches compared with 6 inches for GaAs).

A solution to this problem seems to be found with reference to a receiving substrate, an InP layer taken off and obtained by metamorphic epitaxy of a buffer layer on a GaAs substrate.

Certain taking-off processes, such as a process of the "etch-back" type, then lead to destruction of the remaining part of the substrate and of the buffer layer during taking-off.

In some other taking-off processes, such as a Smart-cut© process, the substrate is recycled but the buffer layer is lost.

US 2002/0072130 describes such a process for forming a semi-conductor structure. A graded Si₁₋ₓGeₓ buffer layer is deposited on a first silicon donor wafer. A relaxed SiGe layer is formed on the buffer layer. After ions implantation, bonding and annealing, a SiGe film is transferred on a receiving wafer comprising a SiO₂ layer.

However, only the first silicon donor wafer is reused for a subsequent useful layer transfer. The buffer layer is lost each time the process is carried out.

It is known from EP0955671 that the step of useful layer transfer causes the creation of projecting parts on the periphery of the donor wafer. In EP0955671, the reuse of the donor wafer comprises a removal of said projecting parts, in particular through CMP, which greatly reduces the thickness of the donor wafer, and thus implies the regrowth of the lost layers.

However, the metamorphic production technique is complex.

Optimizing and producing such a buffer layer may therefore involve a lengthy, difficult and expensive operation.

Furthermore, internal strains due to the variations in composition may cause the appearance of a high rate of crystalline defects, such as dislocations and point defects.

These internal strains, and therefore the generation of defects, may be minimized in particular by increasing the thickness over which the lattice parameter varies.

It is mainly for this reason that the buffer layers usually produced are thick, with a typical thickness ranging from one to a few micrometers.

However, economic and technical restraints limit some essential properties of the buffer layer, such as its thickness or a certain structural complexity.

For all these reasons among others, it would be wise to avoid completely forming a buffer layer after each recycling of the substrate.

The present invention intends to achieve this aim by providing a method according the claim 1.

In the method of recycling according to the invention, a protective layer is further present in the donor wafer so that at least a part of the buffer structure underlies it; the material of the protective layer being chosen from crystalline materials such that means for removing substance has an etching power which is substantially different for the material of the protective layer than for the material of at least one of the two adjacent zones, and thus is able to operate a selective chemical removal of substance.

According to a second aspect, a method of producing a donor wafer intended to provide a useful layer by taking-off and capable of being recycled after taking-off according to said preferred method of recycling, is characterized in that it comprises the following steps:
- formation of a first part of a buffer structure on a substrate;
- formation of a protective layer on the first part of the buffer structure, in a material chosen from crystalline materials;
- formation on the protective layer of the second part of the buffer structure, such that it has a lattice parameter in the vicinity of the protective layer substantially the same as that of the first part of the buffer structure in the vicinity of the protective layer.

According to a third aspect, a method of taking off a useful layer on a donor wafer in order to be transferred to a receiving substrate, is characterized in that it comprises:
(a) bonding the donor wafer to the receiving substrate;
(b) detaching a useful layer bonded to the receiving substrate from the donor wafer,
(c) recycling the donor wafer according to said method of recycling.

According to a fourth aspect, a method of cyclically taking off a useful layer from a donor wafer, is characterized in that it comprises several steps of taking off a useful layer, each of these steps complying with the said method of taking-off.

According to a fifth aspect, an application of the said method of cyclically taking-off or of the said method of taking-off is provided, for producing a structure comprising the receiving substrate and the useful layer, the useful layer comprising at least one of the following materials:
SiGe, Si, an alloy belonging to the III-V family, the composition of which is respectively chosen from the possible (Al,Ga,In)-(N,P,As) combinations.

According to a sixth aspect, donor wafers are provided.
Figure 1 shows a donor wafer according to the prior art.
Figure 2 shows a donor wafer after taking-off.
Figure 3 shows a donor wafer after a first recycling step.
Figure 4 shows a first donor wafer.
Figure 5 shows a second donor wafer.
Figure 6 shows a third donor wafer.
Figure 7 shows the various steps of a method according to the invention successively comprising taking-off of a thin layer from a donor wafer and recycling of the donor wafer after taking-off.

The main object of the present invention consists in recycling a wafer comprising a buffer structure (i.e. any structure behaving as a buffer layer), after at least one useful layer has been taken off the wafer so as to integrate this useful layer into a semiconductor structure, the recycling including at least partial recovery of the buffer structure so that it can be reused in a subsequent taking-off.

The said recycling operation must therefore comprises a suitable treatment which does not damage at least part of the buffer structure.

Indeed, a buffer structure usually contains crystallographic defaults, such as dislocations, which can propagate and increase in size in an important manner when energy is supplied on it, this energy could provide from thermal treatments, chemical process or mechanical process.

For instance, if a buffer structure of SiGe is heated at a temperature of 350°C, 450°C or 550°C, the structural state change with respect to the temperature chosen (see for instance the document "Structural characterisation and stability of Sil-xGex/Si(100) heterostructures grown by molecular beam epitaxy" of Re et al., in the Journal of Crystal Growth, vol. 227-228, pp. 749-755, July 2001). With the increase of temperature, the buffer structure will tend to decrease its internal stress by relaxing them in slip planes, stacking defaults or other structural relaxation types. This can bring some future difficulties at the interface with the useful layer to be formed. It is then important to keep these internal stress confined in the buffer structure.

Recycling must then carried out in a manner, with adapted means for recycling, so as to prevent and limit the extension of these crystalline stress inside the buffer structure which can damage its properties and which can thus damage the properties of the useful layer formed on it.

Advantageously, the buffer structure has a crystallographic structure which is substantially relaxed and/or without a noteworthy number of structural defects on the surface.

A "buffer layer" is as already defined more generally above in this document.

Advantageously, a buffer layer is comprised in the buffer structure and has at least one of the two following functions:
1. decreasing the density of defects in the upper layer;
2. matching a lattice parameter of two crystallographic structures with different lattice parameters.

With regard to the second function of the buffer layer, the latter is an interlayer between the two structures, and around one of its faces it has a first lattice parameter substantially identical to that of the first structure and around its other face, it has a second lattice parameter substantially identical to that of the second structure.

In the rest of this document, the buffer layers or structures described will comply with this latter buffer layer. .

Furthermore, an example of a method not forming part of the invention will be described below, including recycling a donor wafer of a useful layer by taking-off, the donor wafer initially consisting of a support substrate and a buffer structure.

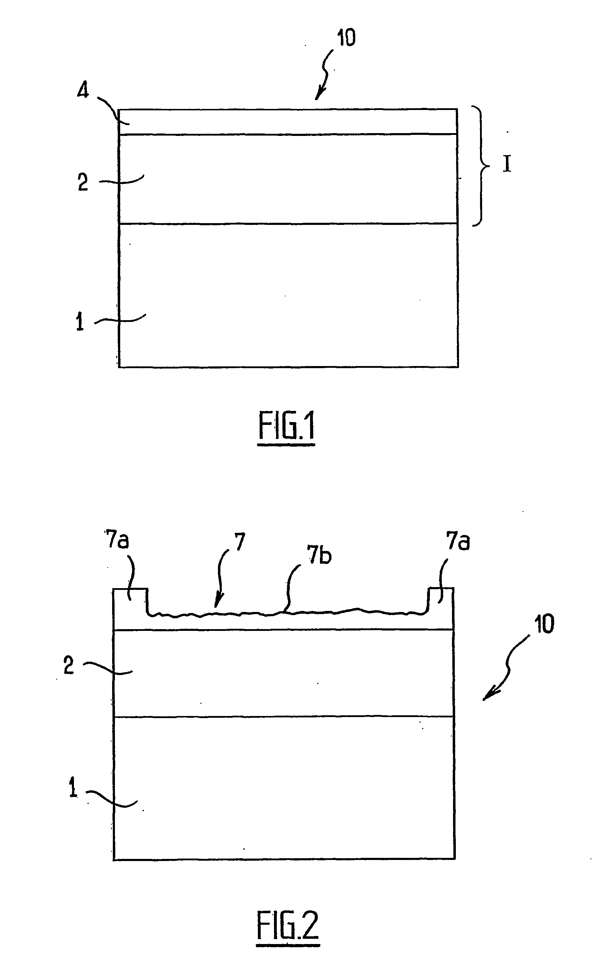

With reference to Figure 1, a donor wafer 10 (donor of a thin layer by taking-off) included in the known prior art consists of a support substrate 1 and a buffer structure I.

The application for this donor wafer 10 is that of taking off a useful layer, from the part 4 of the buffer structure I and/or at least part of an overlayer formed on the surface of the buffer structure I (not shown in Figure 1), in order to integrate it into a structure, such as an SOI structure.

The support substrate 1 of the donor wafer 10 comprises at least one semiconductor layer having a first lattice parameter at its interface with the buffer structure I.

In a particular configuration, the support substrate 1 consists of a single semiconductor having the first lattice parameter.

In a first configuration of the buffer structure I, the latter consists of a buffer layer 2.

The buffer layer 2, located on the support substrate 1, in this case makes it possible to present at its surface a second lattice parameter substantially different from the first lattice parameter of the substrate 1, and thus to have, in the same donor wafer 10, two layers 1 and 4 respectively having different lattice parameters.

Furthermore, the buffer layer 2 may make it possible, in some applications, for the overlying layer to prevent the latter from containing a high defect density and/or being subject to noticeable stresses.

Furthermore, the buffer layer 2 may make it possible, in some applications, for the overlying layer to have a good surface condition.

In general, the buffer layer 2 has a lattice parameter which changes gradually with thickness in order to establish the transition between the two lattice parameters.

Such a layer is generally called a metamorphic layer.

This gradual change of the lattice parameter may be produced continuously within the thickness of the buffer layer 2.

Alternatively, it may be carried out in "stages", each stage being a thin layer with a substantially constant lattice parameter which is different to that of the underlying stage, so as to discretely change the lattice parameter stage by stage.

It may have also have a more complex form, such as a variation in composition with a variable rate, a sign inversion of the rate or discontinuous jumps in composition.

The change of the lattice parameter in the buffer layer 2 is advantageously found by increasing therein, starting from the substrate 1, in a gradual manner, the concentration of at least one atomic element which is not contained in the substrate 1.

Thus, for example, a buffer layer 2 produced on a substrate 1 made of a unitary material could be made of a binary, tertiary, quaternary or higher material.

Thus, for example, a buffer layer 2 produced on a substrate 1 made of a binary material could be made of a tertiary, quaternary or higher material.

The buffer layer 2 is advantageously produced by growth on the support substrate 1, for example by epitaxy, using known techniques such as the CVD and MBE techniques (abbreviations for "Chemical Vapour Deposition" and "Molecular Beam Epitaxy", respectively).

In general, the buffer layer 2 may be produced by any other known method, in order to obtain, for example, a buffer layer 2 consisting of an alloy of various atomic elements.

A minor step of finishing the surface of the substrate 1 underlying the buffer layer 2, for example by CMP polishing, may possibly precede the production of the buffer layer 2.

In a second configuration of the buffer structure I, and with reference to Figure 1, the buffer structure I consists of a buffer layer 2 (substantially identical to that of the first configuration) and of an additional layer 4.

The additional layer 4 may be between the substrate 1 and the buffer layer 1, or on the buffer layer 1, as shown in Figure 1.

In a first particular case, this additional layer 4 may constitute a second buffer layer, such as a buffer layer making it possible to confine defects, and thus to improve the crystalline quality of a layer produced on the buffer structure I.

This additional layer 4 is made of a semiconductor preferably having a constant material composition.

The choice of the composition and of the thickness of such a buffer layer 4 to be produced are then particularly important criteria to achieve this property.

Thus, for example, the structural defects in an epitaxially grown layer usually decrease gradually within the thickness of this layer.

In a second particular case, the additional layer 4 is located on the buffer layer 1 and functions as an upper layer to the buffer layer 2.

Thus it may fix the second lattice parameter.

In a third particular case, the additional layer 4 is located on the buffer layer 1 and plays a role in the taking-off that will be carried out in the donor wafer 10, such as a taking-off at its level.

The additional layer may also have several functions, such as functions chosen from these last three particular cases.

In an advantageous configuration, the additional layer 4 is located on the buffer layer 2 and has a second lattice parameter different from the first lattice parameter of the support substrate 1.

In a particular case of this latter configuration, the additional layer 4 is made of a material relaxed by the buffer layer 2, and has the second lattice parameter.

The additional layer 4 is advantageously produced by growth on the buffer layer 2, for example by epitaxial growth by CVD or MBE.

In a first embodiment, the growth of the additional layer 4 is carried out *in situ,* directly in continuation with the formation of the underlying buffer layer 2, the latter also in this case being advantageously formed by layer growth.

In a second embodiment, the growth of the additional layer 4 is carried out after a minor step of finishing the surface of the underlying buffer layer 2, for example by CMP polishing, heat treatment or other smoothing techniques such that the dislocations and other defaults contained in the buffer layer 2 don't propagate, don't increase in size and don't create any slip planes, stacking defaults or other defaults which can decrease the quality of the final buffer structure I thus formed.

The taking-off of a useful layer from the donor wafer 10 is operated according to one of the following main modes:
(1) the useful layer to be taken off is part of the additional layer 4.
(2) the useful layer to be taken off is part of an overlayer (not shown in Figure 1) which has been formed beforehand on the buffer structure I, for example by epitaxial growth possibly preceded by finishing the surface of the buffer structure I.

The donor wafer 10 then functions as a substrate for the growth of the overlayer.

The latter may comprise one or more thin layers depending on the taking-off mode that it is desired to use.

Furthermore, advantageously, it has a lattice parameter substantially identical to that of the relaxed material of the free face of the buffer structure I, such as a layer of an identical material, or another material which would have all or some of its crystallographic structure strained in tension or in compression, or the combination of these two types of material.

In a particular embodiment of the donor wafer 10, one or more interlayers are furthermore inserted between the buffer structure I and the overlayer. In this case, this or these interlayers are not removed.

(3) The useful layer to be taken off is part of the additional layer 4 and an overlayer (formed in a substantially identical manner to that described in the second taking-off mode).

Whatever the taking-off mode chosen, and with reference to Figure 2, after taking-off and in the majority of cases, projecting parts 7a and/or rough parts 7b appear on the taking-off surface of the remaining donor wafer 10.

This taking-off surface "in relief' belongs to a post-taking-off layer 7 located above the buffer layer 2.

This post-taking-off layer 7 consists of all or some of the layer 4, possibly one or more interlayers and possibly part of an overlayer depending on the taking-off mode chosen from the three previously discussed taking-off modes.

The parts 7a and 7b in relief appearing on the surface of the post-taking-off layer 7 mainly depend on the taking-off mode and on the technique operated during taking-off.
- Thus, for example, a taking-off mode currently used in industry consists in taking off the useful layer not over the entire surface of the donor wafer 10, but only over part of the latter (which is generally a substantially centred part) leaving, on the surface of the donor wafer 10, projecting parts, such as those referenced 7a. These projecting parts are generally integral and located at the periphery of the surface of the donor wafer 10, all the projecting parts then being known in the business as "taking-off ring".
- Thus, for example, known taking-off techniques such as, for example, those that we will study further and later on in this document, such as the Smart-cut© technique already mentioned, sometimes cause surface roughness such as that referenced 7b on the taking-off surface.

Once the taking-off is carried out, recycling is operated in order to restore the donor wafer 10.

Generally, recycling comprises two steps:
- removing substance;
- restoring at least part of the donor wafer 10.

The first step of recycling according to the present invention consists in removing at least the relief parts 7a and 7b (shown in Figure 2).

This removal of substance is operated such that, after the removal, at least part of the buffer structure I remains, which can be used again during subsequent taking-off of a new useful layer.

The remaining part of the buffer structure I, after removal of substance, is thus recycled, unlike the known recycling of the prior art.

In a first particular case of recycling, and concerning the said second mode of taking-off (2), it could be advantageous to choose a thickness of the overlayer so that, after taking-off, the remaining part of the overlayer (which is the post-taking-off layer 7) is removed by standard mechanical means for removing substance, such as polishing means or CMP, without removing substance from the safe buffer structure I, and thus preserve the entire buffer structure I.

Thickness of material removed during the recycling by standard mechanical means like polishing is typically of around 2 micrometers, even if current development succeeds to reach thickness around 1 micrometer.

In a second particular case of recycling, and concerning the said second mode of taking-off (2), it could be advantageous to chose a thickness of the overlayer and of the additional layer 4 so that, after taking-off, the remaining part of the overlayer (which is the post-taking-off layer 7) and at least a part of the additional layer 4 is removed by standard mechanical means for removing substance, such as polishing means or CMP, without removing substance from the safe buffer layer 2, and thus preserve the entire buffer layer 2.For another particular case of recycling, the removal of substance advantageously comprises using of means for chemically attacking materials, such as chemical etching.

The etching may be solely chemical, electrochemical, photo-electrochemical, or any other equivalent etching, such as the etching used during chemical-mechanical polishing.

In an advantageous etching mode, selective retching is carried out.

Thus, in particular, it is possible to use an etching fluid (that is to say a gas or a solution) suitable for carrying out selective etching of a material to be removed from a material to be recycled, the two materials belonging to adjacent layers, so that the material to be recycled forms an etch-stop layer, thus efficiently taking off the part to be removed while protecting the layer to be recycled from the chemical etching.

The property of selectivity between the two materials may, for example, be obtained in at least one of the following cases:
- the two materials are different; or
- the two materials contain atomic elements which are substantially identical except for at least one atomic element; or
- the two materials are substantially identical, but at least one atomic element in one material has an atomic concentration which is substantially different from that of the same atomic element in the other material; or
- the two materials have different porosity densities.

It is known, for example, that SiGe behaves as a stop layer when etching Si with a solution containing compounds such as KOH (potassium hydroxide, selectivity of about 1:100), NH₄OH (ammonium hydroxide, selectivity of about 1:100) or TMAH (tetramethyl ammonium hydroxide).

It is known, for example, that when SiGe has a germanium concentration greater than or equal to 25%, it behaves as a stop layer when etching SiGe having a germanium concentration less than or equal to 20%, with a solution containing compounds such as TMAH.

It is known, for example, that if Si is suitably doped with a doping element at a selected concentration, such as boron at more than 2 x 10¹⁹ cm⁻³, it behaves as a stop layer when etching an undoped Si material with a solution containing compounds such as EDP (ethylenediamine pyrocatechol), KOH or N₂H₂ (hydrazine).

It is known, for example, that porous Si is etched by selective etching with respect to non-porous crystalline Si, with a solution containing compounds such as KOH or HF + H₂O₂.

Thus it is possible to selectively etch the additional layer 4 with respect to the buffer layer 2, and/or the possible overlayer with respect to the additional laver 4 or the possible interlayer.

This removal of substance by chemical means may also be accompanied by using mechanical means for attacking substance or other means.

In particular, it is possible to carry out CMP polishing with a selective chemical etching solution.

This chemical etching may also be preceded or followed by a removal of substance operated by mechanical means of eroding substance such as polishing, grinding, attack or by any other means.

In general, the removal of substance may comprise using any other means of attacking substance capable of removing substance without completely taking off and damaging at least part of the buffer structure I.

One of the following substance removal modes is therefore used:
(a) removing part of the post-taking-off layer 7 comprising at least the relief parts 7a and 7b; or
(b) removing the entire post-taking-off layer 7; or
(c) removing the entire post-taking-off layer 7 and part of the buffer layer 2.

If the post-taking-off layer 7 comprises part of an original overlayer, the substance removal mode (a) then preferably comprises completely taking off this overlayer part.

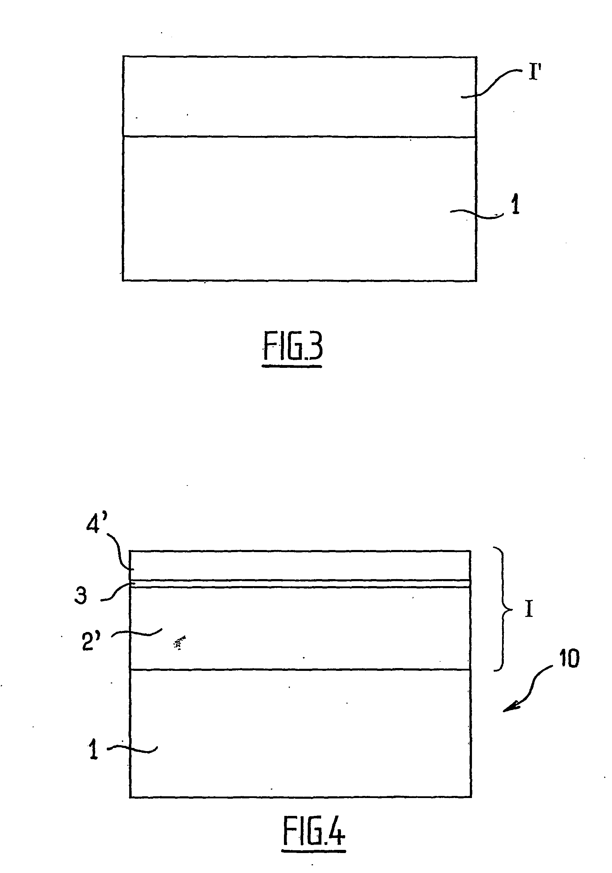

With reference to Figure 3, the part of the original buffer structure which remains after substance removal is referenced I'.

It consists of:
- the entire original buffer structure I when the substance removal mode (a) was used and when the latter did not involve taking off any part of the additional layer 4; or
- the buffer layer 2 and part of the additional layer 4 when the substance removal mode (a) was used and when the latter involved taking off part of the additional layer 4; or
- the buffer layer 2 when the substance removal mode (b) was used; or
- part of the buffer layer 2 when the substance removal mode (c) was used.

The second recycling step comprises, after the first recycling step relating to substance removal, reforming at least some of the layers taken off during the first step.

First of all, and in certain cases, it will be preferred to finish the surface of the donor wafer 10 where the substance removal operated during the first recycling step took place, so as to take off any roughness which may have appeared during the substance removal.

To this end, for example CMP polishing, a heat treatment or another smoothing technique will be used such that the dislocations and other defaults confined in the buffer structure I don't propagate, don't increase in size and don't create any slip planes, stacking defaults or other defaults which can decrease the quality of the buffer structure I.

This second recycling step involves restoring the buffer structure I from the remaining buffer structure I', when part of the original buffer structure I was removed during the first recycling step.

Advantageously, the restoration of the buffer structure I is such that, once formed, the latter is substantially identical to the original buffer structure I.

However, in a particular embodiment, it will be possible to slightly alter some production parameters in order to obtain a buffer structure I which is slightly different from the original. For example, the concentrations of certain compounds in a material will be slightly altered.

Restoring the buffer structure I involves reforming the removed part of the buffer layer 2 when part of the original buffer layer 2 was cut away during the first recycling step.

Restoring the buffer structure I involves reforming all or part of the additional layer 4 when all or part of the original additional layer 4 was cut away during the first recycling step.

In this case, it will be possible to produce an additional layer 4 with a thickness substantially identical to or substantially different from the original.

Once the buffer structure I is restored, an overlayer may possibly be formed above it, which overlayer will at least partly comprise a new useful layer to be taken off, possibly with one or more interlayers between the buffer structure I and the overlayer.

The layers possibly formed during this second recycling step are advantageously produced by layer growth on their respective underlying layers, for example by CVD or MBE epitaxial growth.

In a first case, at least one of these layers is grown *in situ*, directly in continuation with the formation of the underlying growth support, the latter also being formed in this case advantageously by layer growth.

In a second case, at least one of these layers is grown after a minor step of finishing the surface of the underlying growth support, for example by CMP polishing, heat treatment or other smoothing techniques, such that the dislocations and other defaults confined in the buffer structure I don't propagate, don't increase in size and don't create any slip planes, stacking defaults or other defaults which can decrease the quality of the buffer structure I.

Thus, a donor wafer 10 which is substantially identical to the original, that is to say the donor wafer 10 shown in Figure 1, is finally obtained, with the exception of modifications desired and carried out by a person skilled in the art.

The donor wafer 10 obtained in this way comprises at least part of the original buffer structure I, and therefore at least part of the original buffer layer 2, which makes it possible to avoid its complete, lengthy and expensive reformation, as was the case in the known recycling methods.

Donor wafers 10 not forming part of the invention, which can be recycled according to the particular operational modes of the recycling methods presented above, are described in the rest of the document, they provide particularly effective protection for at least part of the buffer structure I during matched recycling.

The donor wafers 10, which are shown in Figures 4, 5 and 6, each involve a substrate 1 and a buffer structure I, like the donor wafer 10 shown in Figure 1.

Each of these donor wafers 10 further comprises a protective layer 3 located in the part located on the same side of the buffer structure I as the interface of the latter with the substrate 1.

A protective layer 3, as defined in the present invention, is made of a material chosen from crystalline materials, such as semiconductors, so as to have the prime function of protecting that part of the donor wafer 10 which is subjacent to it, and which comprises at least part of the buffer structure I, during at least one of the substance removing treatments used during the recycling.

Advantageously, the protective layer 3 is produced by layer growth on the underlying growth support, for example by CVD or MBE epitaxial growth.

In this configuration, and in a first case, the growth of the protective layer 3 is carried out *in situ*, directly in continuation with the formation of the layer which is subjacent to it, the latter also in this case being advantageously formed by layer growth.

In a second case, the growth of the protective layer 3 is carried out after a minor step of finishing the surface of the layer which is subjacent to it, for example by CMP polishing, heat treatment or other smoothing techniques, such that the dislocations and other defaults confined in the buffer structure I don't propagate, don't increase in size and don't create any slip planes, stacking defaults or other defaults which can decrease the quality of the buffer structure I.

The material of the protective layer 3 is chosen such that there is at least one means for removing substance having an ability to attack the material forming the protective layer 3 which is substantially different from the material of at least one of the two zones adjacent to the protective layer 3.

And is thus capable of operating a selective substance removal.

The selective substance removal operated at the protective layer 3 is at least one of the following selective substance removal modes:
- selective removal of the material in the zone adjacent to the protective layer 3 and located on the side of the useful layer which has been taken off, with respect to the protective layer 3, the protective layer 3 forming a stop layer for substance removal;
- selective removal of the material of the protective layer 3, the zone adjacent to the protective layer 3 and located on the side of the substrate 1 as the protective layer 3 forming a layer stopping substance removal.

It is also possible, in one particular operation of selective substance removal, to combine the successive operation of two selective substance removal modes for the same protective layer 3.

Thus, the layer above the protective layer 3, then the protective layer 3 are selectively removed.

Whatever the selective substance removal mode chosen for operation during the first recycling step, and intended to remove that part of the donor wafer 10 located on the side of the taken off useful layer, there is a layer stopping substance removal (the protective layer 3 in the case of the first selective substance removal or the zone adjacent to the protective layer 3 located on the same side of the substrate 1 as the protective layer 3 in the case of the second selective substance removal).

Thus, the stop layer acts as a barrier to the attack of substance, and in the same way, protects the material of the part underlying the protective layer 3 (which comprises at least part of the buffer structure I).

In some cases, it will be desired that the protective layer 3 does not substantially disturb the crystallographic structure of the adjacent layers, and in particular, that it does not disturb the crystalline growth of the underlying layer to be formed, the lattice parameter of which must, in most cases, substantially comply with the lattice parameter of the part underlying the protective layer 3.

This last point is particularly important when the protective layer 3 is located in the buffer structure I (shown in Figure 4).

This result is achieved according to several embodiments of the protective layer 3, as explained below:

In a first embodiment of the protective layer 3, the protective layer 3 is restricted to having its lattice parameter substantially identical to that of the zones which are adjacent to it, even if the nominal lattice parameters of these two materials are substantially different from that of the protective layer 3.

Two main conditions must therefore be met for this operation to succeed:
- the respective nominal parameters of the protective layer 3 and of the zone underlying it do not have values which are too different from each other, so as to avoid the appearance of defects (such as dislocations or local strains) in the protective layer 3;
- the protective layer 3 must be sufficiently thin to prevent progressive relaxation of the strain in the thickness of the layer and/or generation of defects. For this, the thickness of such a protective semiconductor layer 3, made of a strained crystalline material, must be less than a critical thickness known to a person skilled in the art, and especially depending on the materials forming it, the materials of the layers which are adjacent to it, and techniques for producing the strained layer. Critical thicknesses typically encountered are thus less than or equal to several hundred angstroms.

Some examples of "standard critical thickness" can be found in "High-Mobility Si and Ge structures" of Friedrich Schaffler ("Semiconductor Science Technology" 12 (1997) 1515-1549).

In a second embodiment of the protective layer 3, a material is chosen for the protective layer 3 which has a nominal lattice parameter substantially close to that of the materials forming the zones which are adjacent to it.

Thus, unlike the first embodiment, the crystallographic structure of the protective layer 3 is relaxed in this case.

To this end, and also in order to satisfy a criterion of selectivity during substance removal operated during the first recycling step, a material will, for example, be chosen for the protective layer 3. at least one constituent element of which is different from those of the materials which are adjacent thereto, while keeping a lattice parameter close to that of the adjacent zones, this constituent element is thus the main element which will determine the selectivity with respect to the adjacent layer in question.

In a particular case, no constituent element of the material of the protective layer 3 is found in the material constituting the adjacent zone involved in the selective substance removal, the two materials are thus completely different.

In another particular case, each different constituent element of the protective layer 3 with respect to the adjacent zone involved in the selective removal of substance may be an additional element or an element missing from the adjacent layer in question.

For example, it will be possible to dope a protective layer 3 having substantially the same lattice parameter as that of the adjacent zones so as not to substantially disturb this lattice parameter after doping.

If the protective layer 3 consists of the same material as that of the zone which is adjacent thereto and involved in the selective substance removal, this doping element is the element which will then determine the selectivity ability.

In the case of doping the protective layer 3, the thickness of the protective layer 3 must however, in some cases, remain less than a certain critical thickness, known to a person skilled in the art, if it is desired that defects, such as dislocations, in particular of the screw type, are not to appear.

In a third embodiment of the protective layer 3, the surface of a previously produced layer is made porous in order to form a porous layer.

This porosification may be carried out by anodization, by implantation of atomic species, or by any other porosification technique, as described, for example, in document EP 0 849 788 A2.

This layer of porous material may produce, when at least one adjacent material may undergo a selective substance attack determined by a suitable attack means, a protective layer 3.

This protective layer 3 is preferably between two adjacent layers, that is to say between the layer whose surface has been porosified and a layer formed on the layer of porous material, having substantially identical respective materials.

Since the porosity does not substantially disturb the crystallographic structure of these two adjacent layers, such a protective layer 3 therefore does not substantially disturb the crystallographic structure of the donor wafer 10.

Thus, a crystallographic structure is obtained for the protective layer 3 which is very close or even substantially identical to that of the zones which are adjacent thereto, the protective layer 3 therefore not disturbing the crystallography of the surrounding structure.

However, in other cases, it will be possible to have a protective layer 3 having some influence on the lattice parameter of the surrounding structures, the complete or relative strain or relaxation state that the protective layer 3 is then capable of causing to the adjacent layers shows, in these particular cases, a property considered as being of minimum benefit for the downstream application.

Several selective substance removal techniques may be operated at the protective layer 3.

A first selective substance removal technique, not forming part of the invention, consists in applying friction forces to the protective layer 3 in order to take off at least part of the substance to be removed.

These friction forces may, for example, be applied by a polishing plate, possibly combined with abrasive action and/or chemical action.

The material which forms the protective layer 3 is chosen from crystalline material so that there is a mechanical substance attack method having a mechanical attack power which is substantially different for the material forming the protective layer 3 than for the material of at least one of the two zones adjacent to the protective layer 3, and thus being capable of operating at least one selective mechanical attack method.

The selective mechanical attack method is therefore one of the following mechanical attack methods:
- selective mechanical attack of the material of the zone adjacent to the protective layer 3 and located on the side as the useful layer which has been taken off, with respect to the protective layer 3.

The material of the protective layer 3 thus has properties of withstanding mechanical attack which are substantially greater than in the region which lies over it.

For this purpose, it is possible for example to harden the protective layer 3 with respect to the overlying layer, in a manner suitable for the mechanical attack method chosen to remove the overlying zone.

Thus, for example, it is known that carbonated Si, with a typical C concentration of between 5% and 50%, is harder than uncarbonated Si.
- Selective mechanical attack of the material of the protective layer 3, the zone adjacent to the protective layer 3 and located on the same side of the substrate 1 with regard to the protective layer 3 forming an etch-stop layer.

The material of the protective layer 3 has properties of withstanding mechanical attack, and especially erosion, which are substantially less than in the zone which lies over it.

For example, it is possible to soften the protective layer 3 with respect to the underlying layer, in a manner suitable for the substance removal technique chosen to remove the protective layer 3.

A second selective substance removal technique, forming part of the invention, consists in chemically etching the substance to be removed.

Wet etching may be operated with etching solutions suitable for the materials to be removed.

Dry etching may also be operated in order to remove substance, such as plasma etching or sputtering.

Furthermore, the etching may be solely chemical, electrochemical or photo-electrochemical.

The material which forms the protective layer 3 is chosen from the crystalline materials so that there is an etching fluid (a gas or a solution) having an ability to etch the material forming the protective layer 3 which is substantially different from the material of at least one of the two zones adjacent to the protective layer 3, and thus being capable of carrying out at least one selective etching method.

The selective etching method is one of the following etching methods:
- selective etching of the material of the zone adjacent to the protective layer 3 and located on the side of the useful layer which has been taken off, with respect to the protective layer 3, the protective layer 3 forming an etch-stop layer;
- selective etching of the material of the protective layer 3, the zone adjacent to the protective layer 3 and located on the same side of the substrate 1 with respect to the protective layer 3 forming an etch-stop layer.

Whatever the selective etching method likely to be operated during the recycling and intended to remove that part of the donor wafer 10 located on the same side of the taken off useful layer, there is an etch-stop layer (the protective layer 3 in the case of the first etching method or the zone adjacent to the protective layer 3 located on the same side of the substrate 1 as the protective layer 3 in the case of the second selective etching method).

Thus, the stop layer acts as a barrier to chemical etching, and in the same way protects the material of the part underlying the protective layer 3 (which comprises at least part of the buffer structure I).

As has already been stated above, the selectivity for removing substance between the material of the protective layer 3 and the material of the adjacent zone involved in the selective etching may be obtained by the fact that:
- the two materials are different; or
- the two materials contain substantially identical atomic elements, except for at least one atomic element; or
- the two materials are substantially identical, but at least one atomic element in one material has an atomic concentration which is substantially different from that of the same atomic element in the other material; or
- the two materials have different porosity densities.

With reference to Figure 4, the protective layer 3 is within the buffer structure I, the donor wafer 10 thus comprises a structure consisting of the following four successive layers: the support substrate 1, a lower part 2' of the buffer structure I, the protective layer 3 and the upper part 4' of the buffer structure I.

Here, the protective layer 3 makes it possible to protect the lower part 2' of the buffer structure I.

Recycling such a donor wafer 10 according to the invention consists, during a first step, in taking off all of the part located on the same side of the upper part 4' of the buffer structure I as the protective layer 3.

At the protective layer 3, the selective substance removal mode is at least one of the following selective substance removal modes:
- removal of the material from the zone of the part 4' adjacent to the protective layer 3, the protective layer 3 forming a layer stopping the removal of substance;
- removal of material from the protective layer 3, the zone of the part 2' adjacent to the protective layer 3 forming a layer stopping the removal of substance.

Whatever the selective substance removal mode likely to be operated during the recycling and intended to remove the part 4' adjacent to the protective layer 3, there is a layer stopping the removal of substance (the protective layer 3 in the case of the first selective substance removal mode or the zone of the part 2' adjacent to the protective layer 3, in the case of the second selective substance removal mode), thus acting as a barrier to substance attack or etching, and in the same way protecting the material of the lower part 2' of the buffer structure I.

So that the crystallographic structure of the buffer structure I is not substantially disturbed, this type of protective layer 3 must have its own crystallographic structure which is substantially identical to that of the zone adjacent to the buffer structure I, and must therefore be produced according to an embodiment which makes it possible to obtain this material property, such as one of the three embodiments already discussed.

After the said removal of the substance lying over the lower part 2' of the buffer structure I, the recycling advantageously comprises production of a new upper part 4' of the buffer structure I, and possibly of a new protective layer 3 where the latter has been removed (during the second selective substance removal mode mentioned above or by a treatment suitable for removing this layer 3).

These layers 3 and 4' may be grown *in situ* or after a minor step of finishing the surface of the donor wafer 10 on which the growth(s) will take place, for example by CMP polishing, heat treatment or other smoothing techniques, such that the dislocations and other defaults confined in the buffer structure I don't propagate, don't increase in size and don't create any slip planes, stacking defaults or other defaults which can decrease the quality of the buffer structure I.

The lower part 2' of the buffer structure I is therefore preserved during recycling, which is not the case with the methods of the prior art.

In a particular and advantageous configuration of the donor wafer 10, the lower part 2' of the buffer structure I is a buffer layer, and the upper part 4' of the buffer structure I is an additional layer to the buffer layer, such as the buffer layer 2 and additional layer 4 shown in Figure 1 and discussed above.

This particular configuration has the advantage of protecting the buffer layer 2', that is to say, that part of the buffer structure I which is generally the most difficult, the longest and the most expensive to produce.

Since the additional layer 4' is usually formed by epitaxial growth, combined with fixed parameters (such as for example the concentration of the elements to be epitaxially grown, the temperature, the pressure, the atmosphere, the growth speed and rate, etc.), and is itself the subject of taking-off during the step of taking off the layer from the donor wafer 10, protecting this additional layer 4' by the protective layer 3 during recycling does not seem necessary.

However, in another particular configuration of the donor wafer 10, the protective layer 3 can be located within the additional layer 4' in order to protect at least part thereof.

And in another particular configuration, the protective layer 3 is formed inside the buffer layer 2' in order to protect only part thereof, for example the part which is most difficult to produce.

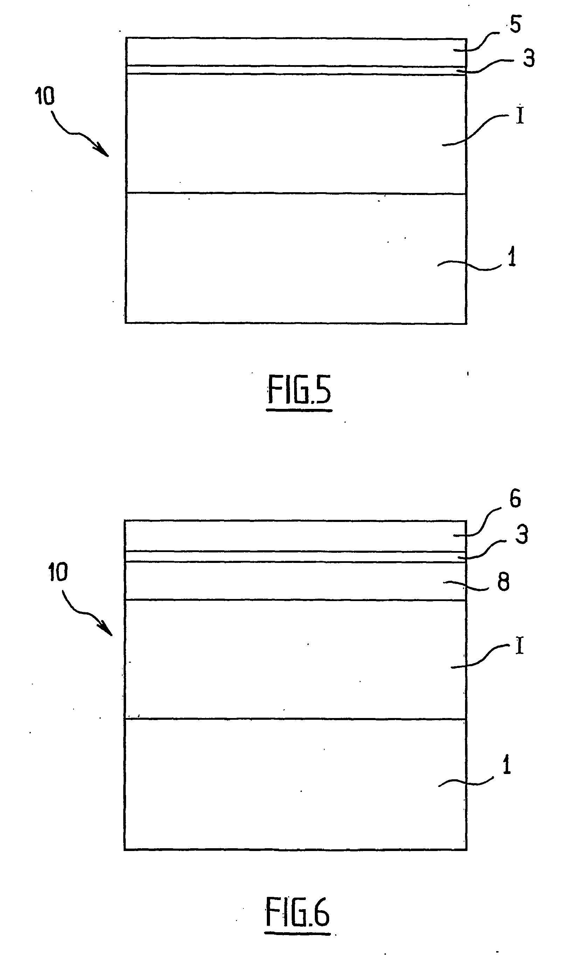

With reference to Figure 5, a second donor wafer 10 differs mainly from the donor wafer 10 shown in Figure 2 in that the protective layer 3 is no longer located in the buffer structure I, but directly over the buffer structure 1.

Furthermore, an overlayer 5 is present on the protective layer 3, in which at least part of a useful layer will be taken off on transfer of a layer from the donor wafer 10.

The composition and the crystallographic structure of this overlayer 5 will be chosen depending on the physical, electrical and/or mechanical properties that it is desired to obtain in the post-transfer structure.

The material of this overlayer 5 may, for example, have a nominal lattice parameter substantially identical to that of the buffer structure I in its part adjacent to the protective layer 3, so as to preserve a substantially relaxed structure.

The material of this overlayer 5 may also have, for example, a nominal lattice parameter substantially different from that of the buffer structure I in its part adjacent to the protective layer 3, and have a thickness which is sufficiently small so that it has to preserve the lattice parameter of the buffer structure I in its part adjacent to the protective layer 3, and thus be strained.

The material of this overlayer 5 may again be chosen, for example, in order to have a structure intermediate between a strained structure and a relaxed structure.

In an advantageous configuration, the overlayer 5 is produced by layer growth, for example by CVD or MBE epitaxial growth.

In this configuration, and in a first case, the growth of the overlayer 5 is carried out *in situ*, directly in continuation with the formation of the upper part of the buffer structure I, the latter in this case also being advantageously formed by layer growth.

In a second case, the growth of the overlayer 5 is carried out after a minor step of finishing the surface of the upper surface of the underlying buffer structure I, for example by CMP polishing, heat treatment or other smoothing techniques, such that the dislocations and other defaults confined in the buffer structure I don't propagate, don't increase in size and don't create any slip planes, stacking defaults or other defaults which can decrease the quality of the buffer structure I.

With regard to the protective layer 3, its role in this case is to protect substantially all of the underlying buffer structure I and the substrate 1 from the substance removal operated during the first recycling step.

The recycling of such a donor wafer 10, after a useful layer has been taken off from it in the overlayer 5, consists, during a first step, in taking off substantially all of the part located on the same side of the overlayer 5 as the protective layer 3.

At the protective layer 3, the selective substance removal mode is at least one of the following selective substance removal modes:
- removal of the material of the overlayer 5 adjacent to the protective layer 3, the protective layer 3 forming a layer stopping the removal of substance;
- removal of material of the protective layer 3, the zone of the buffer structure I adjacent to the protective layer 3 forming a layer stopping the removal of substance.

Whatever the selective substance removal mode likely to be operated during recycling and intended to remove the remaining overlayer 5, there is a layer stopping the removal of substance (the protective layer 3 in the case of the first selective substance removal mode or the zone of the upper part of the buffer structure I, adjacent to the protective layer 3, in the case of the second selective substance removal mode), thus acting as a barrier to substance etching or attack, and in the same way protecting the material of the buffer structure I.

Furthermore, if may be advantageous that the protective layer 3 does not substantially disturb the crystallographic structure of the directly underlying buffer structure I, and does not disturb the crystalline growth of the overlying overlayer 5, in order to preserve the influence of the structure of the buffer structure I on the structure of the overlayer 5 being grown, and is therefore advantageously produced according to one of the three embodiments already discussed.

After the said removal of the substance overlying the buffer structure I, the recycling advantageously comprises producing a new overlayer 5, and possibly a new protective layer 3 in the case where the latter has been removed (during the second selective substance removal mode mentioned above or by a treatment suitable for removing this layer 3).

These layers 5 and 3 may be grown *in situ* or after a minor step of finishing the surface of the donor wafer 10 on which the growth(s) will take place, for example by CMP polishing, heat treatment or other smoothing techniques such that the dislocations and other defaults confined in the buffer structure I don't propagate, don't increase in size and don't create any slip planes, stacking defaults or other defaults which can decrease the quality of the buffer structure I.

With reference to Figure 6, a third donor wafer 10 differs mainly from the donor wafer 10 shown in Figure 3 by the fact that there is an interlayer 8 between the buffer structure I and the protective layer 3.

The composition and the crystallographic structure of this interlayer 8 will be chosen as a function of the physical, electrical and/or mechanical properties that it is desired to obtain.

The material of the interlayer 8 may, for example, have a nominal lattice parameter which is substantially identical to that of the buffer structure I in its part adjacent to its interface, so as to preserve a substantially relaxed structure. In this case, the interlayer 8 is an extension of the buffer structure I, which may for example further reinforce the crystallographic rigidity of the growth surface of the overlayer 5.

The material of this interlayer 8 may also have, for example, a nominal lattice parameter which is substantially different from that of the buffer structure I in the part adjacent to its interface, and have a thickness which is low enough to have to preserve the lattice parameter of the buffer structure I in its part adjacent to the protective layer 3, and thus be strained.

In an advantageous configuration, the interlayer 8 or the overlayer 5 is produced by layer growth, for example by CVD or MBE epitaxy.

In this configuration, and in a first case, the growth of the layer in question is carried out *in situ*, directly in continuation with the formation of the underlying layer, the latter in this case also advantageously being formed by layer growth.

In a second case, the growth of the layer in question is carried out after a minor step of finishing the surface of the upper surface of the underlying layer, for example, by CMP polishing, heat treatment or other smoothing techniques, such that the dislocations and other defaults confined in the buffer structure I don't propagate, don't increase in size and don't create any slip planes, stacking defaults or other defaults which can decrease the quality of the buffer structure I.

With regard to the protective layer 3, its role in this case is to protect virtually the entire underlying interlayer 8, the entire buffer structure I and the substrate 1 from the substance removal operated during the first recycling step.

At the protective layer 3, the selective substance removal mode is at least one of the following selective substance removal modes:
- removal of the material of the overlayer 5 adjacent to the protective layer 3, the protective layer 3 forming a layer stopping the removal of substance;
- removal of the material of the protective layer 3, the zone of the interlayer 8 adjacent to the protective layer 3 forming a layer stopping the removal of substance.

Whatever the selective substance removal mode likely to be operated during the recycling and intended to remove the remaining overlayer 5, there is a layer stopping the removal of substance (the protective layer 3 in the case of the first selective substance removal mode or the zone of the interlayer 8 adjacent to the protective layer 3, in the case of the second selective substance removal mode), thus acting as a barrier to substance etching or attack, and in the same way protecting the material of the buffer structure I.

Furthermore, it may be advantageous that the protective layer 3 does not substantially disturb the crystallographic structure of the directly underlying interlayer 8, and does not disturb the crystalline growth of the overlying overlayer 5, in order to preserve the influence of the structure of the interlayer 8 on the structure of the overlayer 5 being grown, and must therefore be produced according to one of the two embodiments already discussed.

After the said removal of the substance overlying the interlayer 8, the recycling advantageously comprises producing a new overlayer 5, and possibly a new protective layer 3 in the case where the latter has been removed (during the second selective substance removal mode mentioned above or by a treatment suitable for removing this layer 3).

These layers 5 and 3 may be grown *in situ* or after a minor step of finishing the surface of the donor wafer 10 on which the growth(s) will take place, for example, by CMP polishing, heat treatment or other smoothing techniques, performed such that the dislocations and other defaults confined in the buffer structure I don't propagate, don't increase in size and don't create any slip planes, stacking defaults or other defaults which can decrease the quality of the buffer structure I.

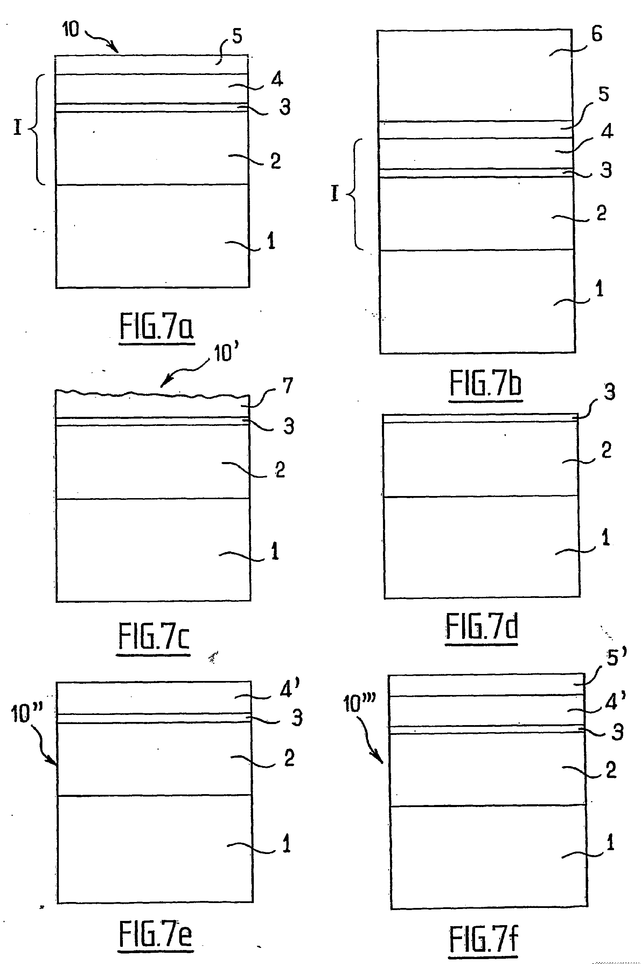

With reference to Figures 7a to 7f, the various steps are shown of a method of taking off a thin layer from and of recycling a donor wafer 10 comprising a protective layer 3, which uses a donor wafer 10 with a layer structure substantially identical to that described above with reference to Figure 4 and which therefore comprises, with reference to Figure 7a, a substrate 1, and a buffer structure I within which there is a protective layer 3.

In the example which we will study, the protective layer 3 takes off a buffer layer 2 and an additional layer 4 in the buffer structure I.

In this exemplary method according to the invention, an overlayer 5 has been added above the additional layer 4.

The removal that will be carried out during this method will relate to taking off part of the additional layer 4 and of the overlayer 5.

In the same way and in other structural configurations of the donor wafer 10, there may be several overlayers and the taking-off would then relate to the overlayers and possibly part of the additional layer 4, or there may be no overlayer and the taking-off would then relate to only part of the additional layer 4.

Furthermore, it is often necessary to have a fairly thin protective layer 3: as already explained above, too thick a protective layer 3 could influence the crystalline properties of the buffer structure I, such as generating defects, for example dislocations, or changes in the lattice parameters.

For this, the thickness of the protective layer 3 must be less than a critical thickness beyond which the undesirable effects would be obtained in this case.

These four layers 2, 3, 4 and 5 have advantageously been formed by epitaxial growth according to known techniques, for example by CVD and MBE,

In a first case, at least one of these four layers is grown *in situ,* directly in continuation with the formation of the underlying growth support, the latter also being in this case advantageously formed by layer growth.

In a second case, at least one of these four layers is grown after a minor step of finishing the surface of the underlying growth support, for example by CMP polishing, heat treatment or other smoothing techniques, performed such that the dislocations and other defaults confined in the buffer structure I don't propagate, don't increase in size and don't create any slip planes, stacking defaults or other defaults which can decrease the quality of the buffer structure I.

A method of taking off a thin layer is shown in Figures 7b and 7c.

A first preferred taking-off step of the invention consists in creating a fragile zone in the additional layer 4, in order to carry out a subsequent detachment, and thus separate the desired layer(s).

Several techniques that can be operated to create such a fragile zone are presented here:
A first technique, called Smart-cut®, known to a person skilled in the art (and descriptions of which may be found in a number of works covering techniques for reducing wafers) consists, in its first step, in implanting atomic species (such as hydrogen ions) with a particular energy in order to create in this way a fragile zone.
A second technique consists in forming a fragile interface by creating at least one porous layer, as described for example in document EP-A-0 849 788.

The fragile zone advantageously formed according to one of these two techniques is, in this exemplary method, created between the overlayer 5 and the additional layer 4 or in the additional layer 4.

Where the overlayer 5 is thick enough, the fragile zone may be formed therein. In particular, this is the case where the overlayer 5 consists of a stack of layers.

With reference to Figure 7b, a second step relating to taking off a thin layer consists in attaching a receiving substrate 6 to the surface of the overlayer 5.

The receiving substrate 6 forms a mechanical support which is rigid enough to support the overlayer 5 which will be taken off from the donor wafer 10, and to protect it from any mechanical strains coming from the outside.

This receiving substrate 6 may, for example, be made of silicon or of quartz or of another type of material.

The receiving substrate 6 is attached by placing it in intimate contact with the overlayer 5 and by bonding it thereon, in which molecular adhesion is advantageously carried out between the substrate 6 and the overlayer 5.

This bonding technique, together with variants, is in particular described in the document entitled "Semiconductor Wafer Bonding" (Science and technology, Interscience Technology) by Q.Y. Tong, U. Gösele and Wiley.

If necessary, the bonding is accompanied by a suitable pretreatment of the respective surfaces to be bonded and/or by a supply of heat energy and/or a supply of an additional binder.

Thus, for example, heat treatment applied during or just after the bonding makes it possible to stiffen the bonded connections.

The bonding may also be controlled by a bonding layer, such as silica, inserted between the overlayer 5 and receiving substrate 6, having particularly high molecular bonding abilities.

Advantageously, the material forming the bonding face of the receiving substrate 6 and/or the material of the bonding layer possibly formed, is electrically insulating, in order to produce an SOI structure from the taken off layers the semiconductor layer of the SOI structure then being the overlayer 5 transferred with or without part of the additional layer 4.

Once the receiving substrate 6 is bonded, part of the donor wafer 10 is taken off at the fragile zone formed beforehand, by detaching it.

In the case of the said first technique (Smart-cut®), in a second step, the implanted zone (forming the fragile zone) is subjected to a heat and/or mechanical treatment, or other supply of energy, in order to detach it at the fragile zone.

In the case of the said second technique, the fragile layer is subjected to mechanical treatment or other supply of energy, in order to detach it at the fragile layer.

Detachment at a fragile zone according to one of these two techniques makes it possible to take off most of the wafer 10, in order to obtain a structure comprising possibly the rest of the buffer structure I, the overlayer 5, any bonding layer and the receiving substrate 6.

A step of finishing the surface of the structure formed, at the taken off layer, is then advantageously operated in order to take off any surface roughness, inhomogeneities in thickness and/or undesirable layers, by using, for example, chemical-mechanical polishing CMP, etching or at least a heat treatment.

A post-taking-off layer 7 forms the part, after taking-off, which remains above the protective layer 3, the entire wafer forming a donor wafer 10' to be sent for recycling in order to be reused subsequently during another layer taking-off.

The recycling steps are shown in Figures 7d, 7e and 7f.

With reference to Figure 7d, a first recycling step corresponds to removing virtually all the post-taking-off layer 7 and possibly removing the protective layer 3.

Mechanical or chemical-mechanical attack or a suitable treatment may possibly and first of all be operated in order to remove part of the rest of the additional layer 4 of the post-taking-off layer 7, such as attack by grinding, polishing, CMP, chemical etching, heat treatment and smoothing performed such that the dislocations and other defaults confined in the buffer structure I don't propagate, don't increase in size and don't create any slip planes, stacking defaults or other defaults which can decrease the quality of the buffer structure I.

It is also possible for several of these material etching or attack techniques to be combined or to follow one another, such as for example a succession of attacks by chemical etching and by CMP.

In all cases, the first recycling step comprises using at least one of the selective substance removal modes discussed above.

With reference to Figures 7e and 7f, a second recycling step corresponds to the restoration of layers which are substantially identical to those which existed before taking-off, with the respective formations of an additional layer 4' and of an overlayer 5'.

Furthermore, the restoration comprises the formation of a protective layer 3 where the latter was removed.

The layers are advantageously restored by forming a layer according to a technique which is substantially identical to one of these detailed above.

The layers 4' and 5' obtained of the donor wafer 10"' are not necessarily identical to the layers 4 and 5 of the donor wafer 10, it being possible for the donor wafer shown in Figure 7d to act as a substrate for other types of layers.

In the exemplary method which has just been detailed, the taking-off relates to part of the additional layer 4 and the overlayer 5.

In parallel, this example may be applied to a taking-off concerning only part of the additional layer 4 (the donor wafer 10 not having an overlayer 5).

In parallel, this example may be applied to a taking-off concerning only part of the overlayer 5, and the recycling then comprises removing the remaining part of the overlayer 5.

In the exemplary method which has just been detailed, the protective layer 3 is located between the buffer layer 2 and additional layer 4.

Obviously, this example is applicable also to cases where the protective layer 3 is located in the buffer layer 2 or in the additional layer 4.

In general, this example extends to the case where the protective layer 3 is located in the buffer structure I.

The description of the method with reference to Figures 7a to 7f using a donor wafer 10 shown in Figure 2 can also be easily transposed to donor wafers 10 shown in:
- Figure 5 by locating the protective layer 3 between the buffer structure I and the overlayer 5 instead of placing it within the buffer structure I, the layer then being taken off at the overlayer 5, the taking-off of the substance for recycling ending in selective etching of the overlayer 5 with respect to the protective layer 3 and/or in selective etching of the protective layer 3 with respect to the buffer structure I;
- Figure 6 by adding an interlayer 8 to the donor wafer 10 by locating it between the buffer structure I and the protective layer 3, the layer being taken off at the overlayer 5, the removal of substance for recycling ending in selective etching of the overlayer 5 with respect to the protective layer 3 and/or in selective etching of the protective layer 3 with respect to the interlayer 8.

After recycling the donor wafer 10 according to the invention, a method of taking off a useful layer can then be operated again.

Thus, in an advantageous context of the invention, a cyclic method of taking a useful layer off a donor wafer 10 is operated, by making the following succeed each other repeatedly:
- a taking-off mode; and
- a recycling method according to the invention.

Before operating the cyclic taking-off method, it is possible to implement a method of producing the donor wafer 10 with one or more of the techniques for producing thin layers on a substrate, described above.

In the remainder of this document, we present examples of configurations of donor wafers 10 comprising buffer structures I, and capable of being operated by a method according to the invention.

In particular, we will present materials which can advantageously be used in such donor wafers.

As we have seen, a buffer structure I produced on a substrate 1 having a first lattice parameter has, most of the time, the prime function of having a second lattice parameter on its free face.

Such a buffer structure I then comprises a buffer layer 2 making it possible to produce such matching of a lattice parameter.

The technique most often employed to obtain a buffer layer 2 having this property is to have a buffer layer 2 consisting of several atomic elements comprising:
- at least one atomic element which is in the composition of the substrate 1; and
- at least one atomic element, none or very little of which is in the substrate 1, having a concentration changing gradually within the thickness of the buffer layer 2.

The gradual concentration of this element in the buffer layer 2 will be the main cause of the gradual change of the lattice parameter in the buffer layer 2, in a metamorphic manner.

Thus, in this configuration, a buffer layer 2 will mainly be an alloy.

The atomic elements chosen for the composition of the substrate 1 and for the buffer layer 2 may be of type IV, such as Si or Ge.

For example, in this case, it is possible to have a substrate 1 made of Si and a buffer layer 2 made of SiGe with a Ge concentration changing progressively with thickness between a value close to 0 at the interface with the substrate 1 and a particular value on the other face of the buffer layer 2.

In another scenario, the composition of the substrate 1 and of the buffer layer 2 may comprise pairs of atomic elements of type III-V, such as the possible (AI,Ga,In)-(N,P,As) combinations.

For example, in this case, it is possible to have a substrate 1 made of AsGa and a buffer layer 2 comprising As and/or Ga with at least one other element, the latter element changing progressively with thickness between a value close to 0 at the interface with the substrate 1 and a particular value on the other face of the buffer layer 2.

The composition of the substrate 1 and of the buffer layer 2 may comprise pairs of atomic elements of type II-VI, such as the possible (Zn,Cd)-(S,Se,Te) combinations.

Below, we offer some examples of such configurations:
The first three examples particularly relate to donor wafers 10 comprising a substrate 1 made of Si and a buffer layer 2 made of SiGe and other layers of Si and of SiGe.

These wafers 10 are particularly useful in the case of taking off layers of strained SiGe and/or Si to produce SGOI, SOI or Si/SGOI structures.

In this context, the type of etching solutions used differ depending on the material (Si or SiGe) to be etched. Thus, etching solutions capable of etching these materials will be classed into categories, by attributing an identifier included in the following list to each category:
- S1: selective etching solutions for Si with respect to SiGe such as a solution comprising at least one of the following compounds: KOH, NH₄OH (ammonium hydroxide), TMAH, EDP or HNO₃ or solutions currently being studied combining agents such as HNO₃, HNO₂H₂O₂, HF, H₂SO₄, H₂SO₂, CH₃COOH, H₂O₂ and H₂O, as explained in document WO 99/53539, page 9.
- S2: selective etching solutions for SiGe with respect to Si such as a solution comprising HF:H₂O₂:CH₃COOH (selectivity of about 1:1000) or HNA (hydrofluoric-nitric-acetic solution).
- Sc1: selective etching solutions for SiGe having a Ge concentration substantially less than or equal to 20% with respect to SiGe having a Ge concentration approximately equal to or greater than 25%, such as a solution comprising TMAH or KOH.
- Sd1: selective etching solutions for undoped Si with respect to Si doped with boron, preferably at more than 2 x 10¹⁹ cm⁻³, such as a solution comprising EDP (ethylenediamine pyrocatechol), KOH or N₂H₂ (hydrazine).

Example 1: After recycling, the donor wafer 10 consists of:
- a substrate 1 made of Si;
- a buffer structure I made of SiGe with a buffer layer 2 and an additional layer 4;
- a post-taking-off layer 7 made of Si or of SiGe which forms the rest of an overlayer 5 after taking off part of the latter.

The buffer layer 2 preferably has a Ge concentration progressively increasing from the interface with the substrate 1, in order to make the SiGe lattice parameter change as explained above.

The thickness is typically between 1 and 3 micrometers in order to obtain good structural relaxation at the surface, and to contain the defects associated with the difference in lattice parameter so that they are buried.

The additional layer 4 is made of SiGe substantially relaxed by the buffer layer 2, with a Ge concentration which is advantageously uniform and substantially equal to that of the buffer layer 2 near their interface.

The concentration of germanium in the silicon within the relaxed SiGe layer 4 is typically between 15% and 30%.

This limitation at 30% represents a typical limitation of the current techniques, but may be made to change in the next few years.

The additional layer 4 has a thickness which may vary hugely depending on the case, with a typical thickness of between 0.5 and 1 micron.

In the case where the post-taking-off layer 7 is made of Si, selective etching of the latter with respect to the additional layer 4 made of SiGe may advantageously be operated, with an S1-type etching solution, in order to take it off.

In the case where the post-taking-off layer 7 is made of SiGe and where:
- the Ge concentration in the post-taking-off layer 7 is substantially less than or equal to 20%, and
- the Ge concentration in the additional layer 4 is approximately equal to or greater than 25%,
selective etching of the post-taking-off layer with respect to the additional SiGe layer 4 will be operated, with an Scl-type etching solution, in order to take it off.

In all cases, the last part of the post-taking-off layer 7 is thus completely removed by chemical means, with an etch-stop at the protective layer 3 which thus forms a stop layer, protecting the underlying layers that it is desired to preserve.

Example 2: After recycling, the donor wafer 10 is substantially identical to that presented in example 1, with the exception of the presence of a protective layer 3 within the wafer 10.

The protective layer 3 consists of:
- strained Si; or
- SiGe; or
- boron-doped Si.

It will be recalled that in the case where the protective layer 3 is made of strained Si, the thickness of the protective layer 3 here must not exceed a critical thickness.

Thus, for example, for a protective layer 3 made of strained Si inserted between two SiGe layers respectively having a Ge concentration substantially equal to 20%, the critical thickness is typically equal to about 20 nanometres.

In a first case, the protective layer 3 is located between two SiGe layers.

This is especially the case where the protective layer 3 is located between two layers of the buffer structure I; or between the buffer structure I and a post-taking-off layer 7 made of SiGe; or in the post-taking-off layer made of SiGe.

Several types of etching may thus be operated depending on the material of the protective layer 3:
- If the protective layer 3 is made of strained Si:
   ✔ the overlying part made of SiGe is selectively etched with an S2-type solution;
      and/or:
   ✔ after having removed the post-taking-off layer 7, the protective layer 3 is selectively etched with an S1-type solution.
      - If the protective layer 3 is made of SiGe with a Ge concentration approximately equal to or greater than 25% and if the overlying layer has a Ge concentration substantially less than or equal to 20%:
   ✔ the overlying SiGe part is selectively etched with an Scl-type solution.
      - If the protective layer 3 is made of SiGe with a Ge concentration substantially less than or equal to 20% and if the underlying layer has a Ge concentration approximately equal to or greater than 25%:
   ✔ after having removed the post-taking-off layer 7, the protective layer 3 is selectively etched with an Scl-type solution.

In a second case, the protective layer 3 is located between an underlying SiGe layer and an overlying Si layer.

This is especially the case if the protective layer 3 is located between the buffer structure I and a post-taking-off Si layer 7; or between an SiGe interlayer 8 and a post-taking-off Si layer 7; or in the post-taking-off layer 7 between an SiGe layer and an Si layer.

Several types of etching may then be operated depending on the material of the protective layer 3;
- If the protective layer 3 is made of B-doped Si:
   ✔ the overlying Si part is selectively etched with an Sdl-type solution;
- If the protective layer 3 is made of SiGe:
   ✔ the overlying Si part is selectively etched with an S1-type solution.
      - If the protective layer 3 is made of SiGe with a Ge concentration substantially less than or equal to 20% and if the underlying layer has a Ge concentration approximately equal to or greater than 25%:
   ✔ after having removed the post-taking-off layer 7, the protective layer 3 is selectively etched with an Scl-type solution.

In a third case, the protective layer 3 is located between two Si layers.

This is especially the case if the protective layer 3 is located between an Si interlayer and a post-taking-off Si layer 7; or in the post-taking-off Si layer 7.

Several types of etching may then be operated depending on the material of the protective layer 3:
- If the protective layer 3 is made of B-doped Si:
   ✔ the overlying Si part is selectively etched with an Sdl-type solution;
- If the protective layer 3 is made of SiGe:
   ✔ the overlying Si part is selectively etched with an S1-type solution;
   and/or
   ✔ after having removed the post-taking-off layer 7, the protective layer 3 is selectively etched with an S2-type solution.

Example 3: After recycling, the donor wafer 10 consists of:
- an Si substrate 1;
- a buffer structure I with an SiGe buffer layer 2 and an additional Ge layer 4;
- a post-taking-off AsGa layer 7 which forms the rest of an overlayer 5 after taking off part of the latter;
- a protective AlGaAs layer 3 placed in the post-taking-off layer 7.

The buffer layer 2 preferably has a Ge concentration increasing progressively from the interface with the substrate 1, in order to make the lattice parameter change between that of the Si substrate 1 and that of the additional Ge layer 4.

To this end, in the buffer layer 2, the Ge concentration is made to progress from about 0 to about 100%, or more precisely around 98%, for complete agreement of the theoretical lattice of the two materials.

In a first scenario, the selective chemical etching of the post-taking-off layer 7 with a selective etching solution, such as a solution comprising citric acid (C₆H₈O₇) and hydrogen peroxide having a pH between about 6 and 7 (the selectivity coefficient typically being 20), makes it possible to take off substantially all of the remaining post-taking-off layer 7, the protective layer 3 behaving here like an etch-stop layer.

In a second scenario, after removing part of the post-taking-off layer 7 overlying the protective layer 3, and for an aluminium concentration in the protective layer 3 greater than 20%, selective chemical etching of the protective layer 3 with a selective etching solution, such as a solution comprising diluted hydrofluoric acid (between about 9% and 48%) (the selectivity coefficient typically being between 350 and 10000), makes it possible to take off virtually all of the protective layer 3, the underlying post-taking-off layer 7 behaving here like an etch-stop layer.

In a third scenario, it is possible to make two selective etchings succeed each other in order to remove at least part of the post-taking-off layer 7 and to remove the protective layer 3.

The buffer structure I is thus preserved and is completely recycled.

Example 4: After recycling, the donor wafer 10 consists of:
- a substrate 1 comprising at least one AsGa part at its interface with the buffer structure I;
- at least part of a buffer structure I made of a III-V material;
- a post-taking-off layer 7 comprising a III-V material which constitutes the rest of an overlayer 5 after taking-off of part of the latter.

The prime benefit of this buffer structure I is to match the lattice parameter of the material of the overlayer 5 (whose nominal value is about 5.87 angströms) to that of the AsGa (whose nominal value is about 5.65 angströms).

In the bulk III-V materials, and by comparing bulk InP to bulk AsGa, the latter is less expensive, more widely available on the semiconductor market, less fragile mechanically, a material from which the use of technologies with contact by a rear face is better known, and whose size may reach high values (typically 6 inches instead of 4 inches for bulk InP).

All the benefits which can be offered by such a donor wafer 10 is therefore seen here: this is because it makes it possible to produce an active layer of a III-V material to be transferred with a particular quality and particular properties, which may for example be close to properties that would have been found when producing the latter material in bulk.

In a particular configuration of the donor wafer 10 before taking-off, the overlayer 5 before taking-off comprised InP to be taken off.

Since the bulk InP has a dimension generally limited to 4 inches, the donor wafer 10 gives, for example, a solution to producing an InP layer dimensioned at 6 inches.

A buffer structure I for producing such an overlayer 5 requires a thickness typically greater than one micron, and which will be made to change towards greater thicknesses, especially if it can be recycled according to the present invention.

The epitaxial growth technique usually operated to produce such a buffer structure I is furthermore particularly difficult and expensive, it is therefore beneficial to be able to recover it at least partially after taking off the useful layer.

Advantageously, the buffer structure I comprises a buffer layer 2 consisting of InGaAs with an In concentration changing between 0 and about 53%.

The buffer structure I may further comprise an additional layer 4 made of a III-V material, such as InGaAs or InAlAs, with a substantially constant concentration of the atomic elements.

In a particular taking-off case, the InP overlayer 5 and part of the additional layer 4 will be taken off in order to transfer it to a receiving substrate.

Thus it will be possible to profit from any electrical or electronic properties existing between the two taken off materials.

This is the case, for example, if the part of the additional layer 4 taken off is made of InGaAs or of InAlAs: electronic band discontinuities between the latter material and InP create improved electronic mobilities in the taken off layers.

Other configurations of the donor wafers 10 are possible, comprising other III-V compounds, such as InAlAs or the like.

Typical applications of such layer taking-off are HEMT or HBT ("High-Electron Mobility Transistor" and "Heterojunction Bipolar Transistor", respectively) production.

Chemical etching solutions, which may be selective, suitable for removing some III-V materials with respect to other III-V materials will advantageously be used during the first recycling step.

Thus, for example, in order to remove an InP post-taking-off layer 7 without removing an underlying InGaAs layer, selective etching of InP will advantageously be operated with a solution comprising concentrated HCl.

Example 5: After recycling, the donor wafer 10 consists of:
- a substrate 1 comprising AsGa at its interface with the buffer structure I;
- a buffer structure I comprising InGaAs at its interface with the post-taking-off layer 7;
- an InP post-taking-off layer 7 which forms the rest of an overlayer 5 after taking off part of the latter;
- a protective layer 3 made of InₓGa₁₋ₓAsyP_{1-y} placed between the post-taking-off layer 7 and the buffer structure I; or in the post-taking-off layer 7.

This type of donor wafer 10 (without the protective layer 3) has already been described in example 4.

In a first scenario, the selective chemical etching of the post-taking-off layer 7 with a selective etching solution, such as a solution comprising HF, makes it possible to take off virtually all of the remaining post-taking-off layer 7, the protective layer 3 behaving here like an etch-stop layer.

In a second scenario, after removal of the part of the post-taking-off layer 7 overlying the protective layer 3, the selective chemical etching of the protective layer 3 with a selective etching solution, such as a solution comprising Ce^{IV} H₂SO₄, makes it possible to take off virtually all of the protective layer 3, the layer underlying the protective layer 3 behaving here like an etch-stop layer.

In a third scenario, it is possible to make two selective etchings succeed one another in order to remove at least part of the post-taking-off layer 7 and to remove the protective layer 3.

The buffer structure I is thus preserved and is completely recycled.

Example 6: After recycling, the donor wafer 10 comprises:
- a substrate 1 comprising AsGa at its interface with the buffer structure I;
- a buffer structure I comprising InGaAs;
- an InP protective layer 3 located on or in the InGaAs.

In a first scenario, the selective chemical etching of the InGaAs overlying the protective layer 3 with a selective etching solution, such as a solution comprising Ce^{IV} H₂SO₄, makes it possible to take off virtually all of this material overlying the protective layer 3, the protective layer 3 behaving here like an etch-stop layer.

In a second scenario, after removing the InGaAs overlying the protective layer 3, the selective chemical etching of the protective layer 3 with a selective etching solution, such as a solution comprising HF, makes it possible to take off virtually all of the protective layer 3, the InGaAs underlying the protective layer 3 behaving here like an etch-stop layer.

In a third scenario, it is possible for two selective etchings to succeed one another in order to remove part of the InGaAs and to remove the protective layer 3.

In the semiconductor layers presented in this document, other components may be added to them, such as carbon with a carbon concentration substantially less than or equal to 50% or more particularly with a concentration less than or equal to 5% in the layer in question.

Finally, the present invention is not limited to a buffer structure I, an intermediate layer 8 or an overlayer 5 made of materials presented in the examples above, but extends also to other types of alloys of IV-IV, III-V, II-VI type.

It should be specified that these alloys may be binary, ternary, quaternary or of a higher degree.

## Claims

1. Method of recycling a donor wafer (10) after having taken off at least one useful layer of a material chosen from semiconductor materials, the donor wafer (10) comprising successively
a substrate (1),
a buffer structure (I) comprising a buffer layer (2):
- having around one of its faces a first lattice parameter substantially identical to that of a layer adjacent to said face, and
- around its other face a second lattice parameter substantially identical to that of a layer adjacent to said other face,
- said first lattice parameter being different of said second lattice
parameter,
a protective layer (3) made of a material chosen from crystalline materials placed so that at least a part of the buffer structure underlies it, and adapted to ensure selective chemical etching with respect to at least one of the two zones adjacent to said protective layer (3), and, before taking-off,
a useful layer,
the method comprising removal of substance on the side of the donor wafer (10) where the taking-off took place, **characterized in that** the removal of substance comprises employing selective chemical etching so that, after removal of substance, at least a part of the buffer structure (1) remains, thus being capable of being reused as a buffer structure (1) for a subsequent useful layer taking-off.

2. Method of recycling according to claim 1, **characterized in that**
the material which forms the protective layer is chosen from the crystalline materials so that there is an etching fluid having an ability to etch the material forming the protective layer which is substantially different from the material of at least one of the two zones adjacent to the protective layer, and thus being capable of carrying out at least one selective etching method.

3. Method of recycling according to claim 2, **characterized in that** the selective etching method is one of the following etching methods :
- selective etching of the material of the zone adjacent to the protective layer and located on the side of the useful layer which has been taken off, with respect to the protective layer, the protective layer forming an etch-stop layer ;
- selective etching of the material of the protective layer, the zone adjacent to the protective layer and located on the same side of the substrate with respect to the protective layer forming an etch-stop layer.

4. Method of recycling according to claim 3, **characterized in that** the etch-stop layer acts as a barrier to chemical etching, and in the same way protects the material of the part underlying the protective layer.

5. Method of recycling according to claims 2, 3 or 4, **characterized in that** the selectivity for removing substance between the material of the protective layer and the material of the adjacent zone involved in the selective etching may be obtained by the fact that :
- the two materials are different ; or
- the two materials contain substantially identical atomic elements, except for at least one atomic element; or
- the two materials are substantially identical, but at least one atomic element in one material has an atomic concentration which is substantially different from that of the same atomic element in the other material ; or
- the two materials have different porosity densities.

6. Method of recycling according to claim 1, **characterized in that**, before taking-off, the buffer structure (I) comprises a buffer layer and an additional layer, said additional layer constituting a second buffer layer, said second buffer layer making it possible to confine defects.

7. Method of recycling according to claim 6, **characterized in that** the removal of material comprises the removal of the additional layer (4, 4') remaining after taking-off, the protective layer (3) forming a layer stopping the removal of material.

8. Method of recycling according to claim 6, **characterized in that** the protective layer (3) is between the buffer layer (2) and the additional layer (4').

9. Method of recycling according to claim 1, **characterized in that**,
- the protective layer (3) is located over the buffer structure (I),
- before taking-off, the donor wafer (10) comprises an overlayer (5), disposed on the protective layer (3), which comprises the useful layer to be taken off, and
- after taking-off, the removal of material comprises:
o removal of the material of the overlayer (5) adjacent to the protective layer (3), the protective layer (3) forming a layer stopping the removal of substance, or
o removal of material of the protective layer (3), the zone of the buffer structure (I) adjacent to the protective layer (3) forming a layer stopping the removal of substance

10. Method according to claim 1, **characterized in that**, after recycling, the donor wafer (10) consists of :
- a substrate (1) made of Si;
- a buffer structure (I) made of SiGe with a buffer layer (2) and an additional layer (4);
- a post-taking-off layer (7) made of Si or of SiGe which forms the rest of an overlayer (5) after taking off part of the latter, and
- a protective layer (3), consisting of
o strained Si; or
o SiGe; or
o boron-doped Si.

11. Method according to claim 10, **characterized in that**:
- the buffer layer (2) has a Ge concentration progressively increasing from an interface with the substrate (1), and
- the additional layer (4) is made of SiGe substantially relaxed by the buffer layer (2), with a uniform Ge concentration which is substantially equal to that of the buffer layer (2) near their interface.

12. Method according to claim 1, **characterized in that**, after recycling, the donor wafer (10) consists of:
- an Si substrate (1);
- a buffer structure (1) with an SiGe buffer layer (2) and an additional Ge layer (4);
- a post-taking-off AsGa layer (7) which forms the rest of an overlayer (5) after taking off part of the latter; and
- a protective AlGaAs layer (3) placed in the post-taking-off layer (7).

13. Method of recycling according to claim 1, **characterized in that** the material of the protective layer (3) is being chosen from crystalline materials such that means for removing material has an etching power which is substantially different for the material of the protective layer (3) than for the material of at least one of the two adjacent zones, and thus is able to operate a selective removal of material.

14. Method of recycling according to claim 1, **characterized in that**
- the lattice parameter of the material of the protective layer (3) is restricted to be substantially identical to that of the zones adjacent to said protective layer (3),
- the respective nominal parameters of the protective layer (3) and of the zone underlying it have values which are sufficiently close so as to avoid the appearance of defects in said protective layer (3), and
- the protective layer (3) has a thickness less than a critical thickness, so that to prevent progressive relaxation of the strain in the thickness of the protective layer and/or generation of defects.

15. Method of recycling according to claim 1, **characterized in that** the protective layer (3) is in the buffer structure (I).

16. Method of recycling according to claim 6, **characterized in that** the protective layer (3) is in the additional layer (4').

17. Method of recycling according to claim 1, **characterized in that** the protective layer (3) overlies the buffer structure (I).

## Patentansprüche

1. Verfahren zum Wiederverwerten eines Spenderwafers (10) nach dem Abnehmen wenigstens einer Nutzschicht eines Materials, das unter Halbleitermaterialien ausgewählt wurde, wobei der Spenderwafer (10) nacheinander umfasst
ein Substrat (1),
eine Pufferstruktur (I) mit einer Pufferschicht (2):
- die in der Nähe einer ihrer Seiten einen ersten Gitterparameter aufweist, der im Wesentlichen identisch mit dem einer an diese Seite angrenzenden Schicht ist,
- die in der Nähe ihrer anderen Seite einen zweiten Gitterparameter aufweist, der im Wesentlichen identisch mit dem einer an diese andere Seite angrenzenden Schicht ist,
- wobei der erste Gitterparameter sich vom zweiten
Gitterparameter unterscheidet,
eine Schutzschicht (3), die aus einem Material hergestellt ist, das unter kristallinen Materialien ausgewählt wurde, derart angeordnet ist, dass wenigstens ein Teil der Pufferstruktur unter ihr liegt, und dazu ausgestaltet ist, selektives chemisches Ätzen in Bezug auf wenigstens einen der beiden an die Schutzschicht (3) angrenzenden Bereiche zu ermöglichen, und, vor dem Abnehmen,
eine Nutzschicht,
wobei das Verfahren Entfernen von Substanz auf der Seite des Spenderwafers (10), auf der das Abnehmen stattgefunden hat, umfasst, **dadurch gekennzeichnet, dass** das Entfernen von Substanz das Anwenden von selektivem chemischen Ätzen umfasst, so dass nach dem Entfernen von Substanz wenigsten ein Teil der Pufferstruktur (I) verbleibt, wodurch diese als Pufferstruktur (I) für eine nachfolgende Nutzschichtabnahme wiederverwendet werden kann.

2. Verfahren zum Wiederverwerten nach Anspruch 1, **dadurch gekennzeichnet, dass**
das Material, welches die Schutzschicht bildet, unter den kristallinen Materialien derart ausgewählt wird, dass es ein Ätzfluid mit der Fähigkeit gibt, das die Schutzschicht bildende Material zu ätzen, das sich wesentlich von dem Material wenigstens einer der beiden an die Schutzschicht angrenzenden Bereiche unterscheidet, und wodurch wenigstens ein selektives Ätzverfahren durchgeführt werden kann.

3. Verfahren zum Wiederverwerten nach Anspruch 2, **dadurch gekennzeichnet, dass** das selektive Ätzverfahren eins der folgenden Ätzverfahren ist:
- selektives Ätzen des Materials des Bereichs, der an die Schutzschicht angrenzt und in Bezug auf die Schutzschicht auf der Seite der abgenommenen Nutzschicht angeordnet ist, wobei die Schutzschicht eine Ätz-Stopp-Schicht bildet; und
- selektives Ätzen des Materials der Schutzschicht, wobei der an die Schutzschicht angrenzende und in Bezug auf die Schutzschicht auf derselben Seite des Substrats angeordnete Bereich eine Ätz-Stopp-Schicht bildet.

4. Verfahren zum Wiederverwerten nach Anspruch 3, **dadurch gekennzeichnet, dass** die Ätz-Stopp-Schicht als Barriere für chemisches Ätzen wirkt und auf dieselbe Weise das Material des unter der Schutzschicht liegenden Teils schützt.

5. Verfahren zum Wiederverwerten nach Anspruch 2, 3 oder 4, **dadurch gekennzeichnet, dass** die Selektivität für das Entfernen von Substanz zwischen dem Material der Schutzschicht und dem Material des angrenzenden, in das selektive Ätzen involvierten Bereichs durch die Tatsache erhalten werden kann, dass:
- die beiden Materialien unterschiedlich sind; oder
- die beiden Materialien im Wesentliche identische Atomelemente enthalten, mit der Ausnahme wenigstens eines Atomelements;
- die beiden Materialien im Wesentlichen identisch sind, aber wenigstens ein Atomelement in einem Material eine Atomkonzentration hat, die sich wesentlich von der desselben Atomelements im anderen Material unterscheidet; oder
- die beiden Materialien unterschiedliche Porendichten aufweisen.

6. Verfahren zum Wiederverwerten nach Anspruch 1, **dadurch gekennzeichnet, dass** die Pufferstruktur (I) vor dem Abnehmen eine Pufferschicht und eine Zusatzschicht umfasst, wobei die Zusatzschicht eine zweite Pufferschicht darstellt, die es möglich macht, Defekte zu begrenzen.

7. Verfahren zum Wiederverwerten nach Anspruch 6, **dadurch gekennzeichnet, dass** das Entfernen von Material das Entfernen der Zusatzschicht (4, 4') umfasst, die nach dem Abnehmen zurückbleibt, wobei die Schutzschicht (3) eine Schicht bildet, die das Entfernen von Materials stoppt.

8. Verfahren zum Wiederverwerten nach Anspruch 6, **dadurch gekennzeichnet, dass** die Schutzschicht (3) zwischen der Pufferschicht (2) und der Zusatzschicht (4') liegt.

9. Verfahren zum Wiederverwerten nach Anspruch 1, **dadurch gekennzeichnet, dass**
- die Schutzschicht (3) über der Pufferstruktur (I) angeordnet ist,
- der Spenderwafer (10) vor dem Abnehmen eine Überschicht (5) umfasst, die auf der Schutzschicht (3) angeordnet ist, die die abzunehmende Nutzschicht umfasst; und
- das Entfernen von Material nach dem Abnehmen umfasst:
o Entfernen des an die Schutzschicht (3) angrenzenden Materials der Überschicht (5), wobei die Schutzschicht (3) eine Schicht bildet, welche das Entfernen von Substanz stoppt; oder
o Entfernen von Material der Schutzschicht (3), wobei der an die Schutzschicht (3) angrenzende Bereich der Pufferstruktur (I) eine Schicht bildet, welche das Entfernen von Substanz stoppt.

10. Verfahren nach Anspruch 1, **dadurch gekennzeichnet, dass** der Spenderwafer (10) nach dem Wiederverwerten besteht aus:
- einem Substrat (1) aus Si;
- einer Pufferstruktur (I) aus SiGe mit einer Pufferschicht (2) und einer Zusatzschicht (4);
- einer Nach-Abnahme-Schicht (7) aus Si order SiGe, die den Rest einer Überschicht (5) bildet, nachdem ein Teil der Letzteren abgenommen wurde, und
- eine Schutzschicht (3), bestehend aus:
- gespanntem Si; oder
- SiGe; oder
- mit Bor dotiertem Si.

11. Verfahren nach Anspruch 10, **dadurch gekennzeichnet, dass**
- die Pufferschicht (2) eine Ge-Konzentration aufweist, die sich von einer Grenzfläche mit dem Substrat (1) aus fortschreitend erhöht, und
- die Zusatzschicht (4) aus im Wesentlichen durch die Pufferschicht (2) entspanntem SiGe hergestellt ist, mit einer gleichförmigen Ge-Konzentration, die im Wesentlichen gleich derjenigen der Pufferschicht (2) nahe ihrer Grenzfläche ist.

12. Verfahren nach Anspruch 1, **dadurch gekennzeichnet, dass** der Spenderwafer (10) nach dem Wiederverwerten besteht aus:
- einem Si-Substrat (1);
- einer Pufferstruktur (I) mit einer SiGe-Pufferschicht (2) und einer Ge-Zusatzschicht (4);
- einer AsGa-Nach-Abnahme-Schicht (7), die den Rest einer Überschicht (5) bildet, nachdem ein Teil der Letzteren abgenommen wurde; und
- eine AlGaAs-Schutzschicht (3), angeordnet in der Nach-Abnahme-Schicht (7).

13. Verfahren zum Wiederverwerten nach Anspruch 1, **dadurch gekennzeichnet, dass** das Material der Schutzschicht (3) derart unter kristallinen Materialien ausgewählt wird, dass ein Mittel zum Entfernen von Material eine Ätzkraft aufweist, die sich für das Material der Schutzschicht (3) und für das Material wenigstens eines der beiden angrenzenden Bereiche im Wesentlichen unterscheidet, und daher ein selektives Entfernen von Material betrieben werden kann.

14. Verfahren zum Wiederverwerten nach Anspruch 1, **dadurch gekennzeichnet, dass**
- der Gitterparameter des Materials der Schutzschicht (3) beschränkt ist, im Wesentlichen identisch mit dem der an die Schutzschicht (3) angrenzenden Bereiche zu sein;
- die jeweiligen Nominalparameter der Schutzschicht (3) und des darunterliegenden Bereichs Werte aufweisen, die ausreichend ähnlich sind, um das Auftreten von Defekten in der Schutzschicht (3) zu verhindern, und
- die Schutzschicht (3) eine Dicke aufweist, die kleiner als eine kritische Dicke ist, so dass ein fortschreitendes Nachlassen der Spannung in der Dicke der Schutzschicht und/oder die Erzeugung von Defekten verhindert wird.

15. Verfahren zum Wiederverwerten nach Anspruch 1, **dadurch gekennzeichnet, dass** die Schutzschicht (3) in der Pufferstruktur (I) liegt.

16. Verfahren zum Wiederverwerten nach Anspruch 6, **dadurch gekennzeichnet, dass** die Schutzschicht (3) in der Zusatzschicht (4') liegt.

17. Verfahren zum Wiederverwerten nach Anspruch 1, **dadurch gekennzeichnet, dass** die Schutzschicht (3) über der Pufferstruktur (I) liegt.

## Revendications

1. Procédé de recyclage d'une plaquette donneuse (10) après prélèvement d'au moins une couche utile composée d'un matériau choisi parmi les matériaux semiconducteurs, la plaquette donneuse (10) comprenant successivement :
un substrat (1),
une structure tampon (I) comprenant une couche tampon (2) :
- ayant autour de l'une de ses faces, un premier paramètre de maille sensiblement identique à celui d'une couche adjacente à ladite face, et
- autour de son autre face, un second paramètre de maille sensiblement identique à celui d'une couche adjacente à ladite autre face,
- ledit premier paramètre de maille étant différent dudit second paramètre de maille,
une couche de protection (3) composée d'un matériau choisi parmi les matériaux cristallins, placée de manière à ce qu'au moins une partie de la structure tampon lui soit sous-jacente, et apte à assurer une gravure chimique sélective par rapport à au moins une des deux zones adjacentes à ladite couche de protection (3), et, avant le prélèvement,
une couche utile,
le procédé comprenant l'enlèvement de substance du côté de la plaquette donneuse (10) où le prélèvement a eu lieu, **caractérisé en ce que** l'enlèvement de substance comprend l'utilisation d'une gravure chimique sélective de sorte que, après l'enlèvement de substance, au moins une partie de la structure tampon (I) reste, étant ainsi apte à être réutilisée comme structure tampon (I) au cours d'un prélèvement ultérieur d'une couche utile.

2. Procédé de recyclage selon la revendication 1, **caractérisé en ce que** :
le matériau qui forme la couche de protection est choisi parmi les matériaux cristallins, de sorte qu'il existe un fluide de gravure ayant une capacité à graver le matériau formant la couche de protection, qui est sensiblement différente du matériau d'au moins une des deux zones adjacentes à la couche de protection, étant ainsi apte à mettre en oeuvre au moins un procédé de gravure sélective.

3. Procédé de recyclage selon la revendication 2, **caractérisé en ce que** le procédé de gravure sélective est au moins un des procédés de gravure suivants :
- la gravure sélective du matériau de la zone adjacente à la couche de protection et située du côté de la couche utile qui a été prélevée, par rapport à la couche de protection, la couche de protection formant une couche d'arrêt à la gravure ;
- la gravure sélective du matériau de la couche de protection, la zone adjacente à la couche de protection et située du même côté que le substrat par rapport à la couche de protection formant une couche d'arrêt à la gravure.

4. Procédé de recyclage selon la revendication 3, **caractérisé en ce que** la couche d'arrêt à la gravure joue le rôle de barrière contre une gravure chimique et, de la même manière, protège le matériau de la partie se trouvant sous la couche de protection.

5. Procédé de recyclage selon la revendication 2, 3 ou 4, **caractérisé en ce que** la sélectivité pour enlever la substance entre le matériau de la couche de protection et le matériau de la zone adjacente impliquée dans la gravure sélective peut être obtenue par le fait que :
- les deux matériaux sont différents ; ou
- les deux matériaux contiennent des éléments atomiques sensiblement identiques, sauf pour au moins un élément atomique ; ou
- les deux matériaux sont sensiblement identiques, mais au moins un élément atomique dans un matériau a une concentration atomique sensiblement différente de celle du même élément atomique dans l'autre matériau ; ou
- les deux matériaux ont des densités de porosité différentes.

6. Procédé de recyclage selon la revendication 1, **caractérisé en ce que**, avant le prélèvement, la structure tampon (I) comprend une couche tampon et une couche additionnelle, ladite couche additionnelle constituant une seconde couche tampon, ladite seconde couche tampon permettant de confiner les défauts.

7. Procédé de recyclage selon la revendication 6, **caractérisé en ce que** l'enlèvement de matériau comprend l'enlèvement de la couche additionnelle (4, 4') restant après le prélèvement, la couche de protection (3) formant une couche arrêtant l'enlèvement du matériau.

8. Procédé de recyclage selon la revendication 6, **caractérisé en ce que** la couche de protection (3) se trouve entre la couche tampon (2) et la couche additionnelle (4').

9. Procédé de recyclage selon la revendication 1, **caractérisé en ce que**,
- la couche de protection (3) est située sur la structure tampon (I),
- avant le prélèvement, la plaquette donneuse (10) comprend une surcouche (5), disposée sur la couche de protection (3), qui comprend la couche utile à prélever, et
- après le prélèvement, l'enlèvement de matériau comprend :
- - l'enlèvement du matériau de la surcouche (5) adjacente à la couche de protection (3), la couche de protection (3) formant une couche arrêtant l'enlèvement de substance, ou
- - l'enlèvement du matériau de la couche de protection (3), la zone de la structure tampon (I) adjacente à la couche de protection (3) formant une couche arrêtant l'enlèvement de substance.

10. Procédé selon la revendication 1, **caractérisé en ce que**, après le recyclage, la plaquette donneuse (10) est constituée :
- d'un substrat (1) en Si ;
- d'une structure tampon (I) en SiGe avec une couche tampon (2) et une couche additionnelle (4) ;
- d'une couche post-prélèvement (7) en Si ou en SiGe formant le reste d'une surcouche (5) après le prélèvement d'une partie de cette dernière, et
- d'une couche de protection (3), constituée :
- - de Si contraint ; ou
- - de SiGe ; ou
- - de Si dopé au bore.

11. Procédé selon la revendication 10, **caractérisé en ce que** :
- la couche tampon (2) présente une concentration en Ge augmentant progressivement à partir d'une interface avec le substrat (1), et
- la couche additionnelle (4) est composée de SiGe sensiblement relaxé par la couche tampon (2), avec une concentration uniforme en Ge qui est sensiblement égale à celle de la couche tampon (2) près de leur interface.

12. Procédé selon la revendication 1, **caractérisé en ce que**, après le recyclage, la plaquette donneuse (10) est constituée :
- d'un substrat (1) en Si ;
- d'une structure tampon (I) avec une couche tampon en SiGe (2) et une couche additionnelle en Ge (4) ;
- d'une couche post-prélèvement en AsGa (7) formant le reste d'une surcouche (5) après le prélèvement d'une partie de cette dernière ; et
- d'une couche de protection en AlGaAs (3) placée dans la couche post-prélèvement (7).

13. Procédé de recyclage selon la revendication 1, **caractérisé en ce que** le matériau de la couche de protection (3) est choisi parmi les matériaux cristallins, de manière à ce que le pouvoir de gravure d'un moyen d'enlèvement de matériau pour le matériau de la couche de protection (3) soit sensiblement différent du pouvoir de gravure du moyen d'enlèvement de matériau pour le matériau d'au moins une des deux zones adjacentes, le moyen d'enlèvement de matériau étant ainsi apte à effectuer un enlèvement sélectif de matériau.

14. Procédé de recyclage selon la revendication 1, **caractérisé en ce que** :
- le paramètre de maille du matériau de la couche de protection (3) est restreint de manière à être sensiblement identique à celui des zones adjacentes à ladite couche de protection (3),
- les paramètres nominaux respectifs de la couche de protection (3) et de la zone qui lui est sous-jacente ont des valeurs suffisamment proches afin d'éviter l'apparition de défauts dans ladite couche de protection (3), et
- la couche de protection (3) a une épaisseur inférieure à une épaisseur critique, de manière à empêcher une relaxation progressive de la contrainte dans l'épaisseur de la couche de protection et/ou la génération de défauts.

15. Procédé de recyclage selon la revendication 1, **caractérisé en ce que** la couche de protection (3) est dans la structure tampon (I).

16. Procédé de recyclage selon la revendication 6, **caractérisé en ce que** la couche de protection (3) est dans la couche additionnelle (4').

17. Procédé de recyclage selon la revendication 1, **caractérisé en ce que** la couche de protection (3) recouvre la structure tampon (I).
